# EUROPÄISCHE PATENTSCHRIFT

(11) **EP 3 931 962 B1**
(45) Veröffentlichungstag und Bekanntmachung des Hinweises auf die Patenterteilung: **09.12.2026**
(21) Anmeldenummer: 20705698.7
(22) Anmeldetag: 17.02.2020
(51) Int. Cl.: H03K 5/19, B60T 7/04, H02P 27/06, H03K 7/08, H04J 3/10

(54) **ÜBERTRAGUNG EINES WERTES MITTELS EINES PULSWEITEN-MODULIERTEN SIGNALS**
TRANSFER OF A VALUE THROUGH A PULSE-WIDTH MODULATED SIGNAL
TRANSFERT D'UNE VALEUR PAR UN SIGNAL A MODULATION DE LARGEUR D'IMPULSION

(30) Priorität: 27.02.2019 DE 102019104955
(43) Veröffentlichungstag der Anmeldung: 05.01.2022
(73) Patentinhaber: ZF CV Systems Europe BV, 1170 Brussels (BE)
(72) Erfinder: HECHT, Christian, 31515 Wunstorf (DE); MÜNTEFERING, Dirk, 30900 Wedemark (DE); WURMBÄCK, Tobias, 30952 Ronnenberg (DE)
(74) Vertreter: Rabe, Dirk-Heinrich
(86) Internationale Anmeldenummer: PCT/EP2020/054052
(87) Internationale Veröffentlichungsnummer: WO 2020/173733

(56) Entgegenhaltungen:
- EP-A1- 3 029 829
- WO-A1-98/36956
- DE-A1- 102010 029 847
- DE-A1- 102014 116 906
- DE-A1- 102015 210 789
- DE-A1- 19 853 036

## Beschreibung

Die vorliegende Erfindung bezieht sich auf ein System zur Übertragung eines Wertes mittels eines Pulsweiten-modulierten Signals und ein korrespondierendes Verfahren, welches durch das System ausgeführt werden kann.

Aus dem Stand der Technik sind Systeme zur Übertragung von Werten mittels Pulsweiten-modulierter Signale bekannt, bei denen der zu übertragende Wert durch die Pulsweite der Pulse repräsentiert wird (siehe bspw. DE 10 2006 017 302 B4 und DE 10 2010 029 847 A1). EP 3 029 829 A1 betrifft ein Verfahren zur Übertragung eines Ansteuersignals und eines ersten Datensignals zwischen einer Steuervorrichtung und einer Ansteuervorrichtung einer Leistungshalbleitervorrichtung.

Ein erfindungsgemäßes System zur Übertragung eines Wertes mittels eines Pulsweiten-modulierten Signals umfasst einen Sender und einen Empfänger, die mindestens mit einer Signalleitung und einer Masseleitung miteinander elektrisch verbunden sind. Der Sender ist zur Erfassung des Wertes und zur Ausgabe eines Pulsweiten-modulierten Signals, dessen Pulsweite den Wert oder einen Bereich um den Wert repräsentiert, eingerichtet. Der Empfänger ist eingerichtet, den Wert bzw. den Bereich aus dem ausgegebenen Pulsweiten-modulierten Signal mittels Auswertung der Pulsweite abzuleiten. Der Sender ist ferner eingerichtet, das ausgegebene Pulsweiten-modulierte Signal zurückzulesen und zu überprüfen, ob sich aus dem ausgegebenen Pulsweiten-modulierten Signal der Wert bzw. der Bereich ableiten lässt und, wenn sich der Wert bzw. der Bereich nicht ableiten lässt, ein Fehlersignal an den Empfänger auszugeben.

Dabei ist unter dem Begriff "Wert", wie er in der Beschreibung und den Ansprüchen verwendet wird, insbesondere ein Zahlenwert zu verstehen. Ferner ist unter dem Begriff "Pulsweiten-moduliertes Signal", wie er in der Beschreibung und den Ansprüchen verwendet wird, insbesondere eine Abfolge von Übertragungssequenzen zu verstehen, in denen eine das Signal verkörpernde Spannung zwischen zwei Pegeln wechselt, wobei die Dauer, während der ein bestimmter (konstanter) Pegel ausgegeben wird, aus der zu übertragenden Information, die durch die Dauer eines oder mehrerer Pulse repräsentiert wird, abgeleitet wird. Ferner ist unter dem Begriff "Fehlersignal", wie er in der Beschreibung und den Ansprüchen verwendet wird, insbesondere ein Signal zu verstehen, welches vom Empfänger als nicht-valides Signal interpretiert wird und aus dem dementsprechend (durch den Empfänger) kein Wert bzw. kein Bereich abgeleitet werden kann/wird.

Unter dem Ausgeben eines Pulsweiten-modulierten Signals oder eines Fehlersignals ist dabei zu verstehen, dass immer wenn als das Signal verkörpernde Spannung ein niedriger Pegel ausgegeben wird, die Signalleitung mit der Masseleitung verbunden wird.

Durch das Zurücklesen des ausgegebenen Signals, d.h. durch das Zurücklesen der Spannung auf der Signalleitung, können auf das ausgegebene Signal wirkende Störeinflüsse erkannt und eine Verwendung/Weiterleitung fehlerhafter Werte bzw. Wertebereiche durch den Empfänger verhindert werden, wodurch die Verlässlichkeit der Übertragung erhöht wird. Bspw. kann der Empfänger eingerichtet sein, in Reaktion auf ein Fehlersignal einen oder mehrere als valide angenommene Werte zu verwerfen, so dass der Sender durch Ausgeben des Fehlersignals verhindern kann, dass ein fehlerhafter Wert oder Wertebereich verwendet und/oder weitergeleitet wird.

Der Sender kann ferner eingerichtet sein, ein Pulsweiten-moduliertes Signal auszugeben, dessen Pulsweite in einem vom Sender und vom Empfänger als valide akzeptierten Bereich liegt, wobei das Fehlersignal ein Pulsweiten-moduliertes Signal ist, dessen Pulsweite außerhalb des als valide akzeptierten Bereichs liegt.

Bspw. kann der für Pulsweiten als valide akzeptierte Bereich eine bestimmte anteilsmäßige Dauer einer Übertragungssequenz sein, z. B. ein Bereich zwischen 10% und 90% der Dauer einer Übertragungssequenz. Soll bspw. ein Puls mit einer Pulsweite von 85% (oder 15%) ausgegeben werden und der rückgelesene Puls weist auf Grund einer Störung eine Pulsweite von 75% (oder 25%) auf, kann in Reaktion auf die Störung ein (Fehlersignal mit einem) Puls mit einer Pulsweite von 95% (oder 5%) ausgegeben werden, um dem Empfänger den Übertragungsfehler zu signalisieren.

Der Sender kann ferner eingerichtet sein, das ausgegebene Fehlersignal zurückzulesen und zu überprüfen, ob das Fehlersignal ein Pulsweiten-moduliertes Signal ist, dessen Pulsweite außerhalb des als valid akzeptierten Bereichs liegt.

Bspw. kann gemäß dem obigen Beispiel vorgesehen sein, dass das Fehlersignal eine Pulsweite von 95% (oder 5%) der Dauer einer Übertragungssequenz aufweist, wohingegen der rückgelesene Puls auf Grund der Störung eine geringere (oder größere) Pulsweite aufweist.

Der Sender kann ferner eingerichtet sein, wenn das rückgelesene Fehlersignal ein Pulsweiten-moduliertes Signal ist, dessen Pulsweite innerhalb des als valid akzeptierten Bereichs liegt, das ausgegebene Fehlersignal zu modifizieren, bis das rückgelesene modifizierte Fehlersignal ein Pulsweiten-moduliertes Signal ist, dessen Pulsweite außerhalb des als valid akzeptierten Bereichs liegt.

Bspw. kann der rückgelesene Puls gemäß dem obigen Beispiel auf Grund der Störung eine Pulsweite von 90% (oder 10%) aufweisen, die vom Empfänger als valides Signal und nicht als Fehlersignal interpretiert wird, so dass der Sender die Pulsweite des Fehlersignals weiter modifiziert, um trotz der Störung einen sicheren Empfang des Fehlersignals durch den Empfänger zu ermöglichen.

Der Sender kann ferner eingerichtet sein, ein Pulsweiten-moduliertes Signal auszugeben, dessen Modulationsfrequenz in einem von dem Sender und dem Empfänger als valide akzeptierten Bereich liegt, wobei das Fehlersignal ein Pulsweiten-moduliertes Signal ist, dessen Modulationsfrequenz außerhalb des als valide akzeptierten Bereichs liegt.

Bspw. kann die Länge der Übertragungssequenzen, in denen jeweils ein Puls erzeugt wird, verändert (d. h. verlängert oder verkürzt) werden, so dass sich aus den sich (vergrößernden bzw. verkleinernden) Abständen der Pulsflanken oder Pulsmitten eine geänderte Modulationsfrequenz ableiten lässt.

Der Sender kann ferner eingerichtet sein, das ausgegebene Fehlersignal zurückzulesen und zu überprüfen, ob das Fehlersignal ein Pulsweiten-moduliertes Signal ist, dessen Modulationsfrequenz außerhalb des als valid akzeptierten Bereichs liegt.

Bspw. kann das rückgelesene Fehlersignal auf Grund einer Störung eine unveränderte Modulationsfrequenz aufweisen, so dass das Signal vom Empfänger als valides Signal und nicht als Fehlersignal interpretiert wird. In diesem Fall kann der Sender die Modulationsfrequenz des Fehlersignals weiter modifizieren, um trotz der Störung einen Empfang eines Fehlersignals durch den Empfänger zu erzwingen. Diese Modifikation kann solange/sooft durchgeführt werden, bis sichergestellt ist, dass der Empfänger das Fehlersignal erkennt.

D. h., der Sender kann ferner eingerichtet sein, wenn das rückgelesene Fehlersignal ein Pulsweiten-moduliertes Signal ist, dessen Modulationsfrequenz innerhalb des als valid akzeptierten Bereichs liegt, das ausgegebene Fehlersignal zu modifizieren, bis das rückgelesene modifizierte Fehlersignal ein Pulsweiten-moduliertes Signal ist, dessen Modulationsfrequenz außerhalb des als valid akzeptierten Bereichs liegt.

Ein erfindungsgemäßes Verfahren zum Übertragen eines Wertes mittels eines Pulsweiten-modulierten Signals umfasst ein Ausgeben eines Pulsweiten-modulierten Signals, dessen Pulsweite den Wert oder einen Bereich um den Wert repräsentiert, ein Rücklesen des ausgegebenen Pulsweiten-modulierten Signals, ein Überprüfen, ob sich aus dem ausgegebenen Pulsweiten-modulierten Signal der Wert bzw. der Bereich ableiten lässt, und, wenn sich der Wert bzw. der Bereich nicht ableiten lässt, ein Ausgeben eines Fehlersignals.

Dabei kann das ausgegebene Pulsweiten-modulierte Signal ein Pulsweiten-moduliertes Signal sein, dessen Pulsweite in einem von einem Empfänger als valide akzeptierten Bereich liegt, und das Fehlersignal ein Pulsweiten-moduliertes Signal sein, dessen Pulsweite außerhalb des als valide akzeptierten Bereichs liegt.

Ferner kann das ausgegebene Pulsweiten-modulierte Signal ein Pulsweiten-moduliertes Signal sein, dessen Modulationsfrequenz in einem von einem Empfänger als valide akzeptierten Bereich liegt, wobei das Fehlersignal ein Pulsweiten-moduliertes Signal ist, dessen Modulationsfrequenz außerhalb des als valide akzeptierten Bereichs liegt.

Dabei versteht es sich, dass auch alle weiteren Merkmale und Vorzüge (bevorzugter Ausführungsformen) des erfindungsgemäßen Systems Merkmale und Vorzüge (bevorzugter Ausführungsformen) des erfindungsgemäßen Verfahrens sein können, welches sich auf eine (mögliche) Verwendung des erfindungsgemäßen Systems bezieht.

Die Erfindung wird nachfolgend in der detaillierten Beschreibung anhand von Ausführungsbeispielen erläutert, wobei auf Zeichnungsfiguren Bezug genommen wird, in denen:
Fig. 1 eine schematische Darstellung eines erfindungsgemäßen Systems;
Fig. 2 eine fehlerhafte Übertragung und ein dadurch begründetes Fehlersignal;
Fig. 3 eine schematische Darstellung von Elementen eines erfindungsgemäßen Systems gemäß einem Ausführungsbeispiel; und
Fig. 4 ein Flussdiagramm eines erfindungsgemäßen Verfahrens zeigt.

Dabei sind in den Zeichnungsfiguren gleiche und funktional ähnliche Elemente durch gleiche Bezugszeichen gekennzeichnet. Jedoch versteht es sich, dass nicht notwendigerweise alle Elemente in allen Zeichnungsfiguren gezeigt sind und, dass die gezeigten Elemente lediglich dazu gedacht sind Aspekte der Erfindung zu verdeutlichen.

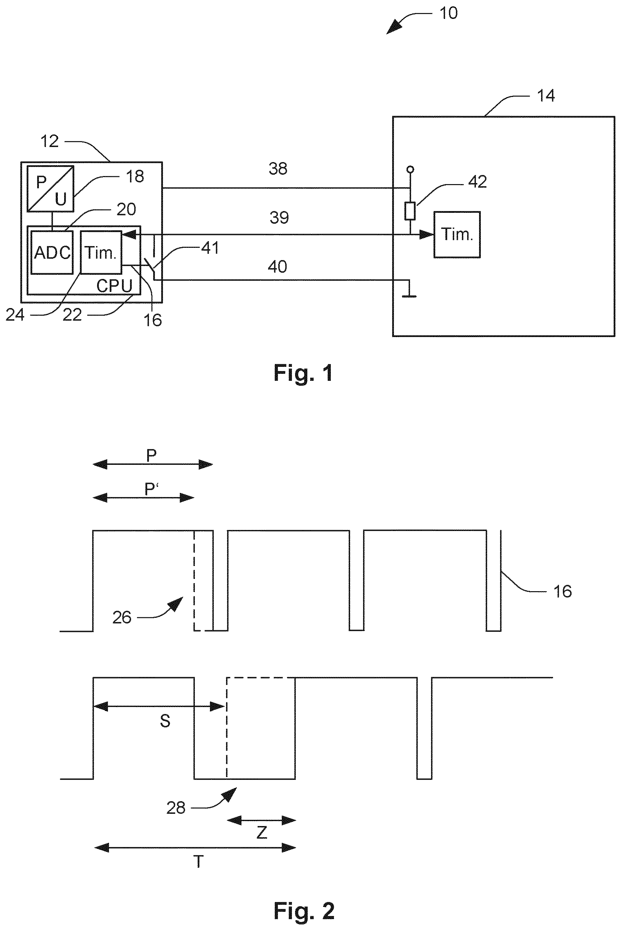

Fig. 1 und Fig. 2 illustrieren die Verwendung eines erfindungsgemäßen Systems 10 zur Übertragung eines Wertes mittels eines Pulsweiten-modulierten Signals 16. Das System 10 umfasst einen Sender 12 (bspw. einen Sensor, insbesondere einen Bremssignalsensor) und einen Empfänger 14, die mindestens mit einer Signalleitung 39 und mit einer Masseleitung 40 miteinander elektrisch verbunden sind. Der Sender 12 ist hier auch mit einer eine Versorgungsspannung aufweisenden Versorgungsleitung 38 mit dem Empfänger 14 verbunden. Der Sender 12 ist eingerichtet, einen Wert zu erfassen und ein Pulsweiten-moduliertes Signal 16, dessen Pulsweite P den Wert oder einen Bereich um den Wert repräsentiert, auszugeben, indem, immer wenn das Pulsweiten-modulierte Signal 16 den niedrigen Pegel aufweist, die Signalleitung 39 mit der Masseleitung 40 mittels des Schalters 41 verbunden wird..

Bspw. kann der Sender 12 einen Messwandler 18 aufweisen, der eine dem Wert bzw. dem Wertebereich entsprechende analoge Spannung erzeugt. Die analoge Spannung kann dann von einem Analog/Digital-Wandler 20 (ADC) einer Recheneinheit 22 (CPU) in ein digitales Signal gewandelt werden, auf dessen Basis ein Timer 24 das Pulsweiten-modulierte Signal 16 erzeugt und mittels des Schalters 41 ausgibt. Der Empfänger 14 ist eingerichtet, den Wert bzw. den Wertebereich aus der das ausgegebene Pulsweiten-modulierte Signal 16 repräsentierenden Spannung auf der Signalleitung 39 mittels Auswertung der Pulsweite P abzuleiten, indem bspw. die Zeit zwischen zwei Signalflanken gemessen wird.

Im Empfänger 14 ist das dortige Ende der Signalleitung 39 über einen ersten Widerstand 42 mit dem dortigen Ende der Versorgungsleitung 38 verbunden. Im ungestörten Fall liegt daher auf der Signalleitung immer dann, wenn sie beim Sender 12 nicht mit der Masseleitung verbunden ist, die Versorgungsspannung an. Im Fall von Störungen kann die Spannung auf der Signalleitung 39 hiervon abweichen.

Um Übertragungsfehler auf Grund von Störungen, die die Pulsweite P verändern, erkennen zu können, ist der Sender 12 ferner eingerichtet, das ausgegebene Pulsweiten-modulierte Signal 16 durch das Zurücklesen der Spannung auf der Signalleitung 39 zurückzulesen und zu überprüfen, ob sich aus ihm der Wert bzw. der Wertebereich (zuverlässig) ableiten lässt. Bspw. kann eine ausgegebene Pulsweite P' von der auszugebenden Pulsweite P bedingt durch eine Störung 26 abweichen, so dass der Empfänger 14 den Wert bzw. den Wertebereich aus dem ausgegebenen Pulsweiten-modulierten Signal 16 nicht ableiten kann.

Um zu verhindern, dass der Empfänger 14 einen falschen Wert bzw. einen falschen Wertebereich weiterverarbeitet oder weiterüberträgt, ist der Sender 12 eingerichtet, ein Fehlersignal 28 an den Empfänger 14 auszugeben. Das Fehlersignal 28 ist dabei ein Signal, das von dem Empfänger 14 keinem (validen) Wert bzw. Wertebereich zugeordnet werden kann und somit dem Empfänger 14 einen Fehler (bspw. eine fehlerhafte Übertragung) anzeigt.

Wie in Fig. 2 gezeigt, kann das Fehlersignal 28 bspw. dadurch erzeugt werden, dass eine Übertragungssequenz S=T-Z (einer Reihe an Übertragungssequenzen gleicher Dauer) um eine Zeitspanne Z verlängert wird. Bspw. kann in der Zeitspanne Z ein invertierter Signalpegel (bspw. ein Low-Pegel anstatt eines High-Pegels) ausgegeben werden, wodurch sich die Modulationsfrequenz so ändert, dass der Empfänger 14 einen Übertragungsfehler erkennt.

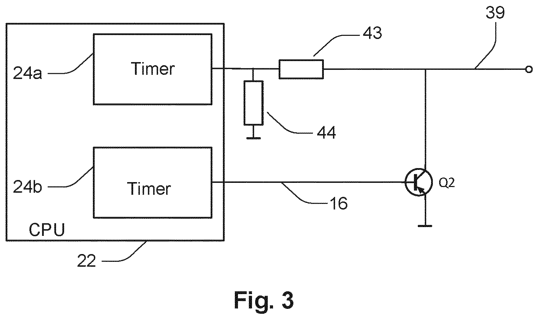

Fig. 3 zeigt eine schematische Darstellung von Elementen eines erfindungsgemäßen Systems 10 gemäß einem Ausführungsbeispiel. In diesem umfasst die Recheneinheit 22 (CPU) zwei Timer 24a, 24b, wobei ein Timer 24b das Pulsweiten-modulierte Signal 16 erzeugt und durch Ansteuerung eines Transistors Q2 ausgibt. Das Verbinden der Signalleitung 39 mit der Masseleitung 40, das in dem in Fig. 1 gezeigten System mittels des Schalters 41 geschieht, wird hier also mittels des Transistors Q2 realisiert, der durch geeignete Ansteuerung in den Durchlasszustand gebracht wird und damit der Signalleitung 39 das Massepotenzial aufprägt. Der andere Timer 24a liest das ausgegebene Signal (bzw. ein aus dem ausgegebenen Signal abgeleitetes Logiksignal) von der Signalleitung 39 über den aus einem zweiten Widerstand 43 und einem drittenWiderstand 44 bestehenden Spannungsteiler zurück, erfasst die Zeitdauern zwischen aufeinanderfolgenden Signalflanken und gleicht diese mit dem auszugebenden Pulsweiten-modulierten Signal 16 ab. Dabei versteht es sich, dass ein separater Timer 24a zum Zurücklesen des ausgegebenen Signals optional ist, und die Signalleitung 39 stattdessen auch mittels eines zyklischen Interrupts durch die Recheneinheit 22 (CPU) abgetastet werden kann.

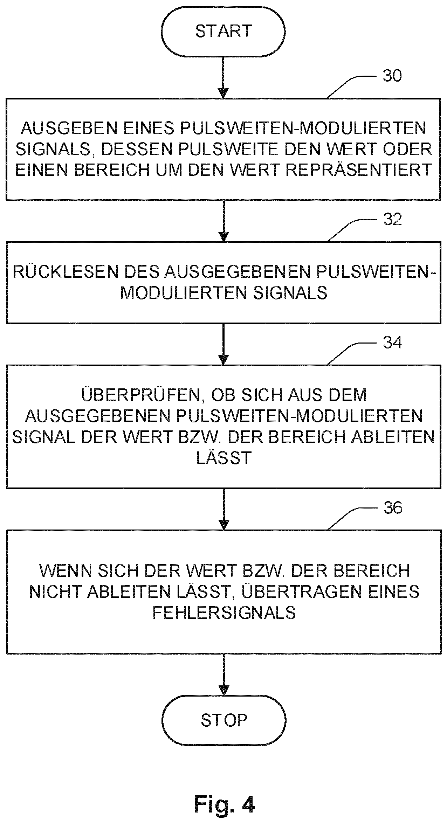

Fig. 4 zeigt ein Flussdiagramm eines erfindungsgemäßen Verfahrens, welches bspw. durch das erfindungsgemäße System 10 ausgeführt werden kann. Das Verfahren startet in Schritt 30 mit dem Ausgeben eines Pulsweiten-modulierten Signals 16, dessen Pulsweite P den Wert oder einen Bereich um den Wert repräsentiert. Bspw. kann eine Pulsweite P von 10% einer Übertragungssequenz S einem Minimalwert und eine Pulsweite P von 90% einer Übertragungssequenz S einem Maximalwert entsprechen.

In Schritt 32 wird das ausgegebene Pulsweiten-modulierte Signal rückgelesen, um relevante Übertragungsstörungen, d. h. Abweichungen zwischen dem Pulsweiten-modulierten Signal 16 und dem tatsächlich ausgegebenen Pulsweiten-modulierten Signal aufzudecken. Relevante Übertragungsstörungen liegen bspw. nicht vor, wenn sich aus dem ausgegebenen Pulsweiten-modulierten Signal der Wert bzw. der Wertebereich (zuverlässig) ableiten lässt, was in Schritt 34 überprüft wird.

Wenn sich der Wert bzw. der Bereich hingegen nicht oder nicht zuverlässig ableiten lässt, wird in Schritt 36 ein Fehlersignal 28 an den Empfänger 14 ausgegeben. Das Fehlersignal 28 kann dabei ein Signal sein, das eine gestörte Übertragung eines Pulsweiten-modulierten Signals 16 weiter modifiziert, so dass empfängerseitig eine Störung der Übertragung sicher erkannt werden kann.

Ferner kann durch ein fortlaufendes Rücklesen der ausgegebenen Signale auf der Signalleitung 39 neben dem Erkennen einer Übertragungsstörung 26 auch ein Überprüfen und ggf. ein Modifizieren des in Reaktion auf die Übertragungsstörung 26 ausgegebenen Fehlersignals 28 erfolgen.

### Bezugszeichenliste

- 10: System
- 12: Sender
- 14: Empfänger
- 16: Pulsweiten-moduliertes Signal
- 18: Messwandler
- 20: Analog/Digital-Wandler
- 22: Recheneinheit
- 24: Timer
- 24a: Timer
- 24b: Timer
- 26: Störung
- 28: Fehlersignal
- 30: Prozessschritt
- 32: Prozessschritt
- 34: Prozessschritt
- 36: Prozessschritt
- 38: Versorgungsleitung
- 39: Signalleitung
- 40: Masseleitung
- 41: Schalter
- 42: erster Widerstand
- 43: zweiter Widerstand
- 44: dritter Widerstand
- P: Pulsweite
- Q2: Transistor
- S: Übertragungssequenz
- T: überlange Übertragungssequenz
- Z: Verlängerungszeitspanne

## Patentansprüche

1. System (10) zur Übertragung eines Wertes mittels eines Pulsweiten-modulierten Signals (16), umfassend:
einen Sender (12), welcher zur Erfassung des Wertes und zur Ausgabe eines Pulsweiten-modulierten Signals (16), dessen Pulsweite (P, P') den Wert oder einen Bereich um den Wert repräsentiert, auf eine Signalleitung (39) eingerichtet ist; und
einen Empfänger (14), welcher eingerichtet ist, den Wert bzw. den Bereich aus einer das Pulsweiten-modulierte Signal (16) repräsentierenden Spannung auf der Signalleitung (39) mittels Auswertung der Pulsweite (P, P') abzuleiten;
wobei der Sender (12) ferner eingerichtet ist, das ausgegebene Pulsweiten-modulierte Signal von der Signalleitung (39) zurückzulesen und zu überprüfen, ob sich aus dem ausgegebenen Pulsweiten-modulierten Signal der Wert bzw. der Bereich ableiten lässt und, wenn sich der Wert bzw. der Bereich nicht ableiten lässt, ein Fehlersignal (28) an den Empfänger (14) auszugeben.

2. System (10) nach Anspruch 1, wobei der Sender (12) ferner eingerichtet ist, ein Pulsweiten-moduliertes Signal (16) auszugeben, dessen Pulsweite (P, P') in einem von dem Sender (12) und dem Empfänger (14) als valide akzeptierten Bereich liegt, wobei das Fehlersignal (28) ein Pulsweiten-moduliertes Signal (16) ist, dessen Pulsweite (P, P') außerhalb des als valide akzeptierten Bereichs liegt.

3. System (10) nach Anspruch 2, wobei der Sender (12) ferner eingerichtet ist, das ausgegebene Fehlersignal von der Signalleitung (39) zurückzulesen und zu überprüfen, ob das ausgegebene Fehlersignal ein Pulsweiten-moduliertes Signal ist, dessen Pulsweite (P, P') außerhalb des als valide akzeptierten Bereichs liegt.

4. System (10) nach Anspruch 3, wobei der Sender (12) ferner eingerichtet ist, wenn das rückgelesene Fehlersignal (28) ein Pulsweiten-moduliertes Signal (16) ist, dessen Pulsweite (P, P') innerhalb des als valide akzeptierten Bereichs liegt, das ausgegebene Fehlersignal (28) zu modifizieren, bis das rückgelesene modifizierte Fehlersignal (28) ein Pulsweiten-moduliertes Signal (16) ist, dessen Pulsweite (P, P') außerhalb des als valide akzeptierten Bereichs liegt.

5. System (10) nach Anspruch 1, wobei der Sender (12) ferner eingerichtet ist, ein Pulsweiten-moduliertes Signal (16) auszugeben, dessen Modulationsfrequenz in einem von dem Sender (12) und dem Empfänger (14) als valide akzeptierten Bereich liegt, wobei das Fehlersignal (28) ein Pulsweiten-moduliertes Signal (16) ist, dessen Modulationsfrequenz außerhalb des als valide akzeptierten Bereichs liegt.

6. System (10) nach Anspruch 5, wobei der Sender (12) ferner eingerichtet ist, das ausgegebene Fehlersignal von der Signalleitung (39) zurückzulesen und zu überprüfen, ob das ausgegebene Fehlersignal ein Pulsweiten-moduliertes Signal (16) ist, dessen Modulationsfrequenz außerhalb des als valide akzeptierten Bereichs liegt.

7. System (10) nach Anspruch 6, wobei der Sender (12) ferner eingerichtet ist, wenn das rückgelesene Fehlersignal ein Pulsweiten-moduliertes Signal (16) ist, dessen Modulationsfrequenz innerhalb des als valide akzeptierten Bereichs liegt, das ausgegebene Fehlersignal zu modifizieren, bis das rückgelesene modifizierte Fehlersignal ein Pulsweiten-moduliertes Signal ist (16), dessen Modulationsfrequenz außerhalb des als valid akzeptierten Bereichs liegt.

8. Verfahren zum Übertragen eines Wertes mittels eines Pulsweiten-modulierten Signals (16), umfassend:
Ausgeben (30) eines Pulsweiten-modulierten Signals, dessen Pulsweite (P, P') den Wert oder einen Bereich um den Wert repräsentiert;
Rücklesen (32) des ausgegebenen Pulsweiten-modulierten Signals (16);
Überprüfen (34), ob sich aus dem ausgegebenen Pulsweiten-modulierten Signal (16) der Wert bzw. der Bereich ableiten lässt; und
wenn sich der Wert bzw. der Bereich nicht ableiten lässt, Ausgeben (36) eines Fehlersignals (28).

9. Verfahren nach Anspruch 8, wobei das ausgegebene Pulsweiten-modulierte Signal (16) ein Pulsweiten-moduliertes Signal ist (16), dessen Pulsweite (P, P') in einem von einem Empfänger (14) als valide akzeptierten Bereich liegt, und das Fehlersignal (28) ein Pulsweiten-moduliertes Signal (16) ist, dessen Pulsweite (P, P') außerhalb des als valide akzeptierten Bereichs liegt.

10. Verfahren nach Anspruch 8, wobei das ausgegebene Pulsweiten-modulierte Signal (16) ein Pulsweiten-moduliertes Signal (16) ist, dessen Modulationsfrequenz in einem von einem Empfänger (14) als valide akzeptierten Bereich liegt, wobei das Fehlersignal (28) ein Pulsweiten-moduliertes Signal (16) ist, dessen Modulationsfrequenz außerhalb des als valide akzeptierten Bereichs liegt.

## Claims

1. System (10) for transmitting a value by means of a pulse-width modulated signal (16), the system comprising:
a transmitter (12), which is configured to detect the value of and to output a pulse-width modulated signal (16), of which the pulse width (P, P') represents the value or a range around the value, to a signal line (39); and
a receiver (14), which is configured to derive the value or range from a voltage, representing the pulse-width modulated signal (16), on the signal line (39) by evaluating the pulse width (P, P');
wherein the transmitter (12) is further configured to read back the output pulse-width modulated signal from the signal line (39) and to check whether the value or range can be derived from the output pulse-width modulated signal and, if the value or range cannot be derived, to output an error signal (28) to the receiver (14).

2. System (10) according to claim 1, wherein the transmitter (12) is further configured to output a pulse-width modulated signal (16) of which the pulse width (P, P') is within a range accepted as valid by the transmitter (12) and the receiver (14), wherein the error signal (28) is a pulse-width modulated signal (16) of which the pulse width (P, P') is outside the range accepted as valid.

3. System (10) according to claim 2, wherein the transmitter (12) is further configured to read back the output error signal from the signal line (39) and to check whether the output error signal is a pulse-width modulated signal of which the pulse width (P, P') is outside the range accepted as valid.

4. System (10) according to claim 3, wherein, if the read-back error signal (28) is a pulse-width modulated signal (16) of which the pulse width (P, P') is within the range accepted as valid, the transmitter (12) is further configured to modify the output error signal (28) until the read-back modified error signal (28) is a pulse-width modulated signal (16) of which the pulse width (P, P') is outside the range accepted as valid.

5. System (10) according to claim 1, wherein the transmitter (12) is further configured to output a pulse-width modulated signal (16) of which the modulation frequency is in a range accepted as valid by the transmitter (12) and the receiver (14), wherein the error signal (28) is a pulse-width modulated signal (16) of which the modulation frequency is outside the range accepted as valid.

6. System (10) according to claim 5, wherein the transmitter (12) is further configured to read back the output error signal from the signal line (39) and to check whether the output error signal is a pulse-width modulated signal (16) of which the modulation frequency is outside the range accepted as valid.

7. System (10) according to claim 6, wherein, if the read-back error signal is a pulse-width modulated signal (16) of which the modulation frequency is within the range accepted as valid, the transmitter (12) is further configured to modify the output error signal until the read-back modified error signal is a pulse-width modulated signal (16) of which the modulation frequency is outside the range accepted as valid.

8. Method for transmitting a value by means of a pulse-width modulated signal (16), the method comprising:
outputting (30) a pulse-width modulated signal of which the pulse width (P, P') represents the value or a range around the value;
reading back (32) the output pulse-width modulated signal (16);
checking (34) whether the value or range can be derived from the output pulse-width modulated signal (16); and,
if the value or range cannot be derived, outputting (36) an error signal (28).

9. Method according to claim 8, wherein the output pulse-width modulated signal (16) is a pulse-width modulated signal (16) of which the pulse width (P, P') is within a range accepted as valid by a receiver (14), and the error signal (28) is a pulse-width modulated signal (16) of which the pulse width (P, P') is outside the range accepted as valid.

10. Method according to claim 8, wherein the output pulse-width modulated signal (16) is a pulse-width modulated signal (16) of which the modulation frequency is in a range accepted as valid by a receiver (14), wherein the error signal (28) is a pulse-width modulated signal (16) of which the modulation frequency is outside the range accepted as valid.

## Revendications

1. Système (10) pour la transmission d'une valeur au moyen d'un signal modulé en largeur d'impulsion (16), comprenant :
un émetteur (12) configuré pour détecter la valeur et pour délivrer en sortie, sur un circuit d'acheminement de signaux (39), un signal modulé en largeur d'impulsion (16) dont la largeur d'impulsion (P, P') représente la valeur ou une plage autour de la valeur ; et
un récepteur (14) configuré pour déduire la valeur ou la plage à partir d'une tension représentant le signal modulé en largeur d'impulsion (16) sur le circuit d'acheminement de signaux (39) au moyen de l'évaluation de la largeur d'impulsion (P, P') ;
dans lequel l'émetteur (12) est en outre configuré pour relire le signal modulé en largeur d'impulsion délivré en sortie provenant du circuit d'acheminement de signaux (39) et pour vérifier si la valeur ou la plage peut être déduite du signal modulé en largeur d'impulsion délivré en sortie et, si la valeur ou la plage ne peut être déduite, pour délivrer en sortie un signal d'erreur (28) au récepteur (14).

2. Système (10) selon la revendication 1, dans lequel l'émetteur (12) est en outre configuré pour délivrer en sortie un signal modulé en largeur d'impulsion (16) dont la largeur d'impulsion (P, P') se situe dans une plage acceptée comme valide par l'émetteur (12) et le récepteur (14), dans lequel le signal d'erreur (28) est un signal modulé en largeur d'impulsion (16) dont la largeur d'impulsion (P, P') se situe en dehors de la plage acceptée comme valide.

3. Système (10) selon la revendication 2, dans lequel l'émetteur (12) est en outre configuré pour relire le signal d'erreur délivré en sortie provenant du circuit d'acheminement de signaux (39) et pour vérifier si le signal d'erreur délivré en sortie est un signal modulé en largeur d'impulsion dont la largeur d'impulsion (P, P') se situe en dehors de la plage acceptée comme valide.

4. Système (10) selon la revendication 3, dans lequel l'émetteur (12) est en outre configuré pour, lorsque le signal d'erreur (28) relu est un signal modulé en largeur d'impulsion (16) dont la largeur d'impulsion (P, P') se situe dans la plage acceptée comme valide, modifier le signal d'erreur (28) délivré en sortie jusqu'à ce que le signal d'erreur (28) modifié relu soit un signal modulé en largeur d'impulsion (16) dont la largeur d'impulsion (P, P') se situe en dehors de la plage acceptée comme valide.

5. Système (10) selon la revendication 1, dans lequel l'émetteur (12) est en outre configuré pour délivrer en sortie un signal modulé en largeur d'impulsion (16) dont la fréquence de modulation se situe dans une plage acceptée comme valide par l'émetteur (12) et le récepteur (14), dans lequel le signal d'erreur (28) est un signal modulé en largeur d'impulsion (16) dont la fréquence de modulation se situe en dehors de la plage acceptée comme valide.

6. Système (10) selon la revendication 5, dans lequel l'émetteur (12) est en outre configuré pour relire le signal d'erreur délivré en sortie provenant du circuit d'acheminement de signaux (39) et pour vérifier si le signal d'erreur délivré en sortie est un signal modulé en largeur d'impulsion (16) dont la fréquence de modulation se situe en dehors de la plage acceptée comme valide.

7. Système (10) selon la revendication 6, dans lequel l'émetteur (12) est en outre configuré pour, lorsque le signal d'erreur relu est un signal modulé en largeur d'impulsion (16) dont la fréquence de modulation se situe dans la plage acceptée comme valide, modifier le signal d'erreur délivré en sortie jusqu'à ce que le signal d'erreur modifié relu soit un signal modulé en largeur d'impulsion (16) dont la fréquence de modulation se situe en dehors de la plage acceptée comme valide.

8. Procédé pour la transmission d'une valeur au moyen d'un signal modulé en largeur d'impulsion (16), comprenant :
la sortie (30) d'un signal modulé en largeur d'impulsion dont la largeur d'impulsion (P, P') représente la valeur ou une plage autour de la valeur ;
la relecture (32) du signal modulé en largeur d'impulsion (16) délivré en sortie ;
le fait de vérifier (34) si la valeur ou la plage peut être déduite du signal modulé en largeur d'impulsion (16) délivré en sortie ; et
si la valeur ou la plage ne peut être déduite, la sortie (36) d'un signal d'erreur (28).

9. Procédé selon la revendication 8, dans lequel le signal modulé en largeur d'impulsion (16) délivré en sortie est un signal modulé en largeur d'impulsion (16) dont la largeur d'impulsion (P, P') se situe dans une plage acceptée comme valide par un récepteur (14), et le signal d'erreur (28) est un signal modulé en largeur d'impulsion (16) dont la largeur d'impulsion (P, P') se situe en dehors de la plage acceptée comme valide.

10. Procédé selon la revendication 8, dans lequel le signal modulé en largeur d'impulsion (16) délivré en sortie est un signal modulé en largeur d'impulsion (16) dont la fréquence de modulation se situe dans une plage acceptée comme valide par un récepteur (14), dans lequel le signal d'erreur (28) est un signal à modulation de largeur d'impulsion (16) dont la fréquence de modulation se situe en dehors de la plage acceptée comme valide.
